# EUROPÄISCHE PATENTANMELDUNG

(11) **EP 2 146 373 A2**
(43) Veröffentlichungstag der Anmeldung: **20.01.2010**
(21) Anmeldenummer: 09008704.0
(22) Anmeldetag: 03.07.2009
(51) Int. Cl.: H01L 23/04, H01L 25/07

(54) **Anordnung mit einem Leistunghalbleitermodul und Verfahren zu deren Herstellung**

(30) Priorität: 19.07.2008 DE 102008033852
(71) Anmelder: Semikron Elektronik GmbH & Co. KG Patentabteilung, 90431 Nürnberg (DE)
(72) Erfinder: Steger, Jürgen, 91355 Hiltpoltstein (DE); Lederer, Marco, 90453 Nürnberg (DE)

(57) **Zusammenfassung**

Die Erfindung betrifft eine Anordnung mit einem Leistungshalbleitermodul (1), umfassend ein Substrat (2) mit mindestens einem Leistungshalbleiterelement (20) und ein Gehäuse (4), und einem Kühlkörper (3) zur Ableitung von Abwärme des mindestens einen Leistungshalbleiterelements (20), wobei das Gehäuse (4) eine an einer dem Kühlkörper (3) zugewandten Unterseite (40) des Gehäuses (4) angeordnete Aussparung (41) zur Aufnahme des Substrats (2) aufweist, sowie ein Verfahren zu deren Herstellung. Das Leistungshalbleitermodul (1) weist mindestens ein Halteelement (5) auf, das in eine dem mindestens einen Halteelement (5) zugeordnete Ausnehmung (42) an der Unterseite (40) des Gehäuses (4) eingreift und so ausgebildet ist, dass es eine Bewegung des Substrats (2) in Richtung zu der Unterseite (40) des Gehäuses (4) begrenzt.

## Beschreibung

Die Erfindung betrifft eine Anordnung mit einem Leistungshalbleitermodul, umfassend ein Substrat mit mindestens einem Leistungshalbleiterelement und ein Gehäuse, und einem Kühlkörper zur Ableitung von Abwärme des mindestens einen Leistungshalbleiterelements, wobei das Gehäuse eine an einer dem Kühlkörper zugewandten Unterseite des Gehäuses angeordnete Aussparung zur Aufnahme des Substrats aufweist. Die Erfindung betrifft weiterhin ein Verfahren zur Herstellung einer solchen Anordnung.

Anordnungen der eingangs genannten Art sind z.B. aus der DE 101 49 886 A1 bekannt. Darin wird ein grundplattenloses Leistungshalbleitermodul beschrieben, bei dem die Unterseite des Substrats durch eine Anpressvorrichtung an einen Kühlkörper, über den beim Betrieb des Leistungshalbleitermoduls in Form von Wärme auftretende Verlustleistungen abgeführt werden, gepresst wird.

Zur Verbesserung des Wärmeübertragung von dem Substrat zu dem Kühlkörper hat es sich als vorteilhaft erwiesen, die Unterseite des Substrats mit einer

Wärmeleitschicht zu beschichten. Beispielsweise kann die Unterseite des Substrats mit einer Wärmeleitpaste bedruckt werden.

Derartige beschichtete grundplattenlose Leistungshalbleitermodule sind bei der Demontage vom Kühlkörper sehr empfindlich. Bei der Demontage des Substrats kann sich, durch die hohen Adhäsionskräfte der Wärmeleitpaste, das Substrat aus dem Gehäuse lösen.

Es ist Aufgabe der Erfindung, eine verbesserte Anordnung der eingangs genannten Art herzustellen. Weiterhin ist es Aufgabe der Erfindung, ein Verfahren zur Herstellung einer solchen verbesserten Anordnung bereit zu stellen.

Die Aufgabe wird für die Anordnung mit einem Leistungshalbleitermodul, umfassend ein Substrat mit mindestens einem Leistungshalbleiterelement und ein Gehäuse, und einem Kühlkörper zur Ableitung von Abwärme des mindestens einen Leistungshalbleiterelements, wobei das Gehäuse eine an einer dem Kühlkörper zugewandten Unterseite des Gehäuses angeordnete Aussparung zur Aufnahme des Substrats aufweist, dadurch gelöst, dass das Leistungshalbleitermodul mindestens ein Halteelement aufweist, das in eine dem mindestens einen Halteelement zugeordnete Ausnehmung an der Unterseite des Gehäuses eingreift und so ausgebildet ist, dass es eine Bewegung des Substrats in Richtung der Unterseite des Gehäuses begrenzt.

Eine derartige Anordnung weist den Vorteil auf, dass sich das Substrat mit den Leistungshalbleiterelementen bei der Demontage von dem Kühlkörper nicht aus dem Gehäuse lösen kann. Das Halteelement hält das Substrat bei der Demontage im Gehäuse. Das Halteelement ermöglicht es, dass das Substrat zusammen mit dem Gehäuse vom Kühlkörper abgelöst werden kann.

Das Halteelement ist nicht an das Gehäuse angeformt bzw. einstückig mit dem Gehäuse ausgebildet, sondern als ein separates, eigenständiges Bauelement ausgebildet, das beim Zusammenfügen der einzelnen Elemente der Anordnung an das Gehäuse montiert wird. Das Halteelement kann aus einem beliebigen Material ausgebildet sein, vorzugsweise aus Kunststoff oder Metall.

Die Aufgabe wird für das Verfahren zur Herstellung einer solchen Anordnung durch folgende Schritte gelöst:
- Bereitstellen eines Substrats mit mindestens einem Leistungshalbleiterelement;
- Einsetzen des Substrats in eine Aussparung eines Gehäuses, die an einer einem Kühlkörper zugewandten Unterseite des Gehäuses angeordnet ist;
- Einbringen mindestens eines Halteelements in eine dem mindestens einen Halteelement zugeordnete Ausnehmung an der Unterseite des Gehäuses zur Begrenzung einer Bewegung des Substrats in Richtung zu der Unterseite des Gehäuses; und
- Montage des Gehäuses auf dem Kühlkörper, wobei die Unterseite des Gehäuses auf dem Kühlkörper angeordnet wird.

Ein derartiges Verfahren ist schnell und unkompliziert durchführbar, wobei sich der oben genannte Vorteil bei der Demontage des Gehäuses von dem Kühlkörper ergibt.

Bevorzugte Ausgestaltungen der Erfindung werden nachfolgend erläutert.

Es hat sich für die Anordnung als vorteilhaft erwiesen, wenn das mindestens eine Halteelement so ausgebildet ist, dass es bei der Montage des Gehäuses auf den Kühlkörper zur Positionierung des Gehäuses auf dem Kühlkörper in eine zugeordnete Ausnehmung des Kühlkörpers eingreift. Dadurch ist eine Zentrierung des Gehäuses, und damit des Substrats, auf dem Kühlkörper möglich. Das Substrat wird mithilfe des Halteelements bei der Montage vorzentriert und ein Verschieben des Substrats bei der Montage vermieden.

Durch diese bevorzugte Ausgestaltung werden die Nachteile vermieden, die sich ergeben, wenn bei der Montage der Anordnung das Gehäuse nicht vorzentriert wird. Durch die fehlende Vorzentrierung besteht nämlich die Gefahr, dass sich während einer nachträglich durchgeführten Positionskorrektur des Gehäuses auf dem Kühlkörper, durch das Haften der Wärmeleitpaste, das Substrat relativ zu dem Gehäuse verschiebt und unter den Gehäuserand ragt, durch den das Substrat dann beschädigt werden kann.

Für das Verfahren hat es sich bewährt, wenn das Aufbringen einer aus einer Wärmeleitpaste gebildeten Wärmeleitschicht auf der den Kühlkörper zugewandten Seite des Substrats erfolgt, bevor das mindestens eine Halteelement in die Ausnehmung des Gehäuses eingebracht wird. Dadurch ist wie bisher das Aufbringen der Wärmeleitpaste auf das Substrat in einem Beschichtungs- oder Druckprozess einfach möglich, ohne dass die Halteelemente stören. Nach Abschluss des Beschichtungs- oder Druckprozesses werden die Halteelemente in die dafür vorgesehenen Ausnehmungen des Gehäuses eingebracht.

Diese bevorzugte Ausgestaltung des erfindungsgemäßen Verfahrens vermeidet also die Nachteile, die sich ergeben, wenn bei der Herstellung des Gehäuses am Gehäuse ein Zentrierungselement angeformt, z.B. angespritzt wird, um die Zentrierung des Gehäuses zu ermöglichen. Das Anformen eines Zentrierungselements am Gehäuse, wie es in bisher bekannten Verfahren praktiziert wird, macht nämlich das Bedrucken eines Substrats, das sich im Gehäuse befindet, mit Wärmeleitpaste unmöglich oder zumindest schwierig. Im Gegensatz zum Stand der Technik kann das erfindungsgemäße Halteelement nach dem Beschichten des Substrats auf dem Gehäuse angeordnet werden.

Weiterhin hat es sich für die Anordnung als vorteilhaft erwiesen, dass die dem mindestens einen Halteelement zugeordnete Ausnehmung des Kühlkörpers und ein dem Kühlkörper zugewandter Abschnitt des Halteelements, der in besagte Ausnehmung eingreift, eine einander entsprechende Form aufweisen. Je besser die Ausnehmung des Kühlkörpers und der darin eingreifende Abschnitt des Halteelements in ihrer Form aufeinander abgestimmt sind, desto präziser kann eine Vorzentrierung des Gehäuses auf dem Kühlkörper erfolgen. In einer bevorzugten Ausgestaltung sind die Ausnehmung des Kühlkörpers und der darin eingreifende Abschnitt des Halteelements in ihrer Form derart aufeinander abgestimmt, dass das Halteelement in der Ausnehmung des Kühlkörpers praktisch keine Bewegung in einer Richtung parallel zu einer Berührungsebene von Kühlkörper und Gehäuse ausführen kann. Auf diese Weise ermöglicht es das Haltelement, dass das Gehäuse eine präzise und vordefinierte Position auf dem Kühlkörper einnimmt.

Besonders bevorzugt ist es, wenn ein dem Kühlkörper zugewandter Abschnitt des Halteelements zylinderförmig ausgebildet ist. Eine bevorzugte Form des dem Kühlkörper zugewandten Abschnitts des Halteelements ist eine zylindrische Form mit einer Fase, d.h., mit einer Abschrägung der dem Kühlkörper zugewandten Kante. Weiterhin ist es bevorzugt, wenn das Halteelement innen hohl ist, z.B. entlang seiner Längsachse eine durchgehende, vorzugsweise zylinderförmige, Aussparung ausweist.

Vorzugsweise weist das mindestens eine Halteelement einen in die Aussparung zur Aufnahme des Substrats hineinragenden Vorsprung auf, der die Bewegung des Substrats in Richtung zu der Unterseite des Gehäuses begrenzt. Der Vorsprung an dem Halteelement ist einfach herzustellen und bildet eine mechanisch zuverlässige Haltevorrichtung.

Weiter bevorzugt ist es, dass das Gehäuse einen umlaufenden Gehäuserahmen aufweist, in dem die Ausnehmung angeordnet ist, in die das Halteelement eingreift.

Besonders hat es sich bewährt, wenn die Ausnehmung an der Unterseite des Gehäuses als ein zu der Unterseite des Gehäuses hin offenes Sackloch ausgebildet ist, in das das mindestens eine Halteelement von der Unterseite des Gehäuses her eingreift.

Insbesondere hat es sich bewährt, dass das mindestens eine Halteelement als ein Rast-Zentrier-Halter ausgebildet ist. Mit einem kombinierten Rast-Zentrier-Halter wird das Leistungsmodul bei der Montage vorzentriert und gleichzeitig ein Verschieben des Substrats bei der Montage vermieden. Gleichzeitig wird durch den Rast-Zentrier-Halter das Substrat bei der Demontage im Gehäuse gehalten. Das Substrat kann somit vom Kühlkörper abgelöst werden.

Vorzugsweise ist das mindestens eine Halteelement mit dem Gehäuse mittels einer lösbaren Verbindung verbunden. Insbesondere hat es sich in diesem Zusammenhang bewährt, wenn die lösbare Verbindung als eine Schraubverbindung ausgebildet ist, d.h. dass das Halteelement an einem in die Ausnehmung des Gehäuses eingreifenden Abschnitt ein Außengewinde und die Ausnehmung des Gehäuses ein dem Außengewinde zugeordnetes Innengewinde aufweist. Es ist auch möglich, dass das Halteelement an einem in die Ausnehmung des Gehäuses eingreifenden Abschnitt mindestens einen federnden Rastfinger und die Ausnehmung des Gehäuses eine dem Rastfinger zugeordnete Rastvertiefung aufweist.

In einer bevorzugten Ausgestaltung der Erfindung ist das mindestens eine Halteelement mittels einer Klebeverbindung in der zugeordneten Ausnehmung des Gehäuses fixiert.

Weiterhin hat es sich bewährt, wenn das Leistungshalbleitermodul mindestens zwei Halteelemente umfasst. In einer besonders bevorzugten Ausgestaltung der Erfindung weist das Leistungshalbleitermodul mindestens drei Halteelemente auf. Die den mindestens zwei Halteelementen zugeordneten Ausnehmungen sind an der Unterseite des Gehäuses vorzugsweise an gegenüberliegenden Seiten des Gehäuses, insbesondere diagonal gegenüberliegend, angeordnet. Die Anordnung von mindestens zwei bzw. mindestens drei Halteelementen hat den Vorteil, dass das Substrat sicher in der Ausnehmung des Gehäuses gehalten wird. Zusätzlich kann es von Vorteil sein, dass die mindestens zwei bzw. mindestens drei Halteelemente eine besonders gute Vorzentrierung des Gehäuses in mehreren Richtungen auf dem Kühlkörper ermöglichen.

Besonders hat es sich bewährt, wenn die Anordnung eine aus einer Wärmeleitpaste gebildete Wärmeleitschicht zwischen dem Substrat und dem Kühlkörper aufweist. Dadurch kann der Wärmeübergang der Abwärme des auf dem Substrat befindlichen Leistungshalbleiterelements zu dem die Abwärme abgebenden Kühlkörper entscheidend verbessert werden.

Für das Verfahren zur Herstellung der Anordnung hat es sich als vorteilhaft erwiesen, wenn die Positionierung des Gehäuses auf dem Kühlkörper so erfolgt, dass das mindestens eine Halteelement in eine zugeordnete Ausnehmung des Kühlkörpers eingreift. Dadurch ist eine Zentrierung des Gehäuses auf dem Kühlkörper möglich.

Anhand der Figuren 1 bis 6d wird die Erfindung beispielhaft erläutert. So zeigen:
- Figur 1: eine perspektivische Ansicht der Unterseite des Gehäuses;
- Figur 2: eine Detailansicht von Figur 1;
- Figur 3a und 3b: Schnitte durch ein Halteelement, das in eine Gehäuseausnehmung eingebracht ist;
- Figur 4: einen Querschnitt durch eine erfindungsgemäße Anordnung;
- Figur 5: einen perspektivischen Schnitt durch ein Halteelement in dem Gehäuserahmen; und
- Figur 6a bis 6d: verschiedene Ansichten eines Halteelements.

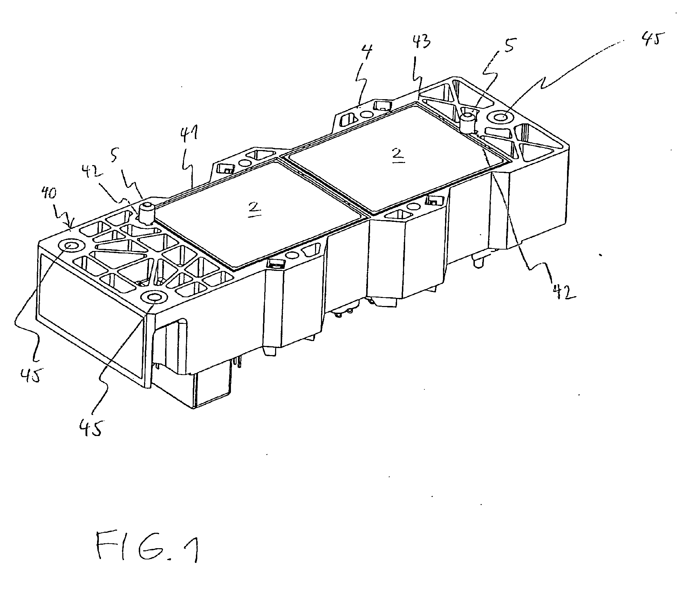

Figur 1 zeigt die Unterseite 40 eines Gehäuses 4, das eine Aussparung 41 zur Aufnahme von zwei Substraten 2 aufweist. Die Substrate 2 können z.B. als DCB-Substrate ausgebildet sein (DCB = Direct Copper Bonded). In dem Gehäuse 4 befinden sich Befestigungslöcher 45, durch die Schrauben geführt werden können, mit denen das Gehäuse 4 auf einem Kühlkörper (nicht dargestellt) montiert wird. Das Gehäuse 4 weist an seiner Unterseite 40 einen umlaufenden Rahmen 43 auf, in dem Ausnehmungen 42 zur Aufnahme von Halteelementen 5 angeordnet sind.

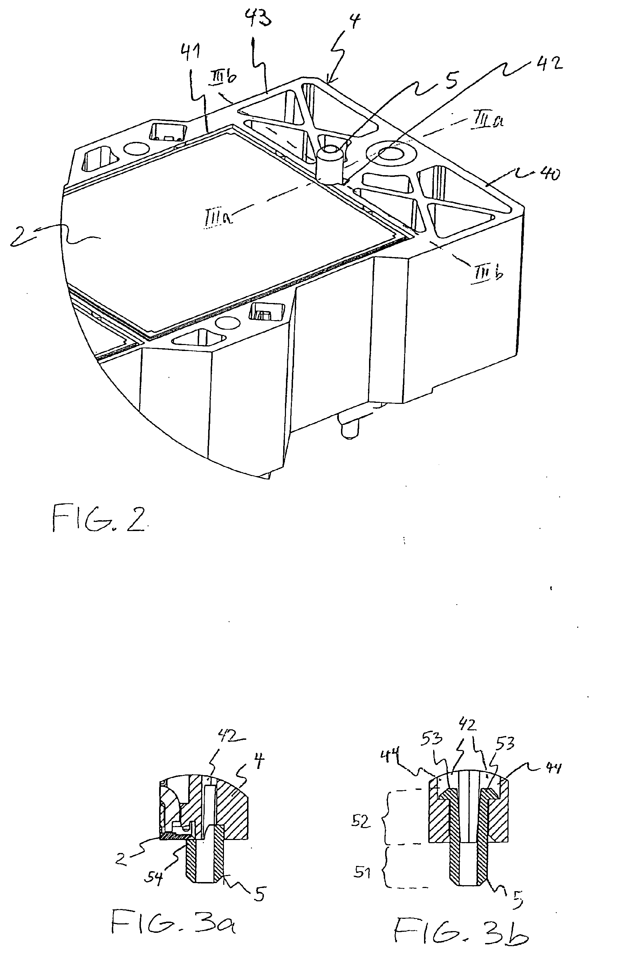

Figur 2 zeigt eine vergrößerte Ansicht des rechten Teiles des in Figur 1 dargestellten Gehäuses 4.

Figur 3a zeigt einen Schnitt durch das in Figur 2 dargestellte Halteelement 5 entlang der in Figur 2 angedeuteten Schnittlinie IIIa. Das Halteelement 5 greift in eine Ausnehmung 42 des Gehäuses 4 ein. Das Halteelement 5 weist einen Vorsprung 54 auf, der an der Unterseite 40 des Gehäuses 4 anliegt. Der Vorsprung 54 des Halteelements ragt von dem umlaufenden Rahmen 43 des Gehäuses 4 in Richtung zu dem Substrat 2. Der Vorsprung 54 dient dem Substrat 2 als Anschlag und begrenzt die Bewegung des Substrats 2 in Richtung zu der Unterseite 40 des Gehäuses 4. Das heißt, das Halteelement 5 fixiert das Substrat und sichert das Substrat 2 gegen ein Herausfallen aus der Ausnehmung 41.

Figur 3b zeigt einen Schnitt durch das Halteelement 5 entlang der in Figur 2 angedeuteten Schnittlinie IIIb. Der dem Kühlkörper 3 zugewandte Abschnitt 51 des Halteelements 5 weist einen becherförmigen Umriss auf. Der in die Gehäuseausnehmung 42 eingreifende Abschnitt 52 des Halteelements 5 weist zwei Rastfinger 53 auf, die in entsprechende Rastvertiefungen 44 der Ausnehmung 42 so eingreifen, dass eine Schnapp-Rast-Verbindung entsteht.

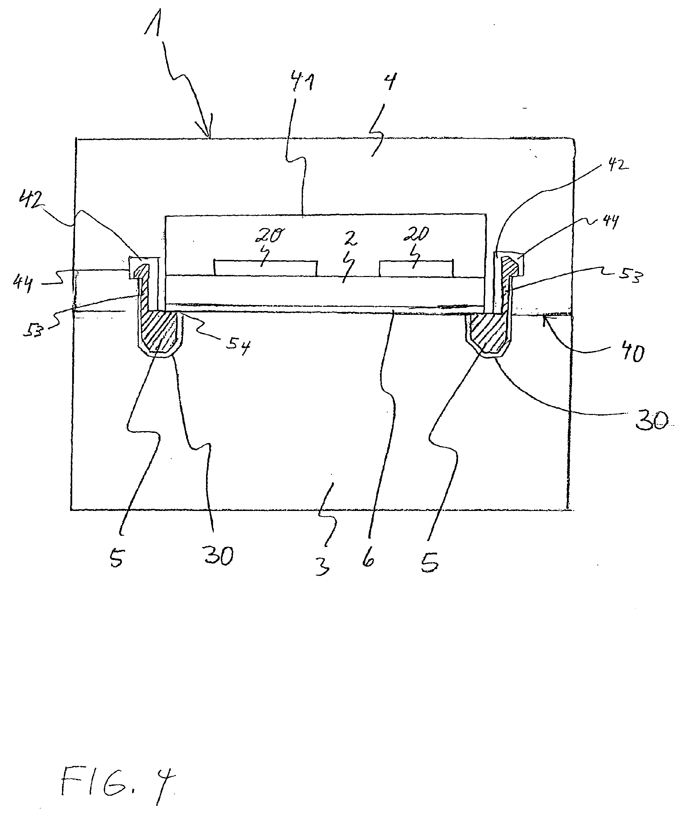

Figur 4 zeigt einen Querschnitt durch eine erfindungsgemäße Anordnung. Die Anordnung weist ein Leistungshalbleitermodul 1, umfassend ein Substrat 2 mit zwei Leistungshalbleiterelementen 20 und ein Gehäuse 4, und einen Kühlkörper 3 zur Ableitung von Abwärme der Leistungshalbleiterelemente 20 auf. Das Gehäuse 4 weist eine an einer dem Kühlkörper 3 zugewandten Unterseite 40 des Gehäuses 4 angeordnete Aussparung 41 zur Aufnahme des Substrats 2 auf. Darüber hinaus weist das Leistungshalbleitermodul 1 zwei Halteelemente 5 auf, die in den Halteelementen 5 zugeordnete Gehäuseausnehmungen 42 an der Unterseite 40 des Gehäuses 4 eingreifen und eine Bewegung des Substrats 2 in Richtung zu der Unterseite 40 des Gehäuses begrenzen. Zwischen dem Substrat 2 und dem Kühlkörper 3 befindet sich eine aus einer Wärmeleitpaste gebildete Wärmeleitschicht 6. Die Gehäuseausnehmungen 42 weisen Rastvertiefungen 44 auf. In diese Rastvertiefungen 44 rasten entsprechende Rastfinger 53 der Halteelemente 5 ein. Mittels der durch die Rastfinger 53 und die Rastvertiefungen 44 gebildeten Rast-Schnapp-Verbindungen werden die Halteelemente 5 in bzw. an dem Gehäuse 4 fixiert. Der Kühlkörper 3 weist zwei Ausnehmungen 30 auf, in die die Halteelemente 5 eingreifen. Die Form der in die Ausnehmungen 30 eingreifenden Abschnitte 51 der Halteelemente 5 ist auf die Form der Ausnehmungen 30 des Kühlkörpers 3 abgestimmt, so dass das Gehäuse 4 nur in einer gewünschten und definierten Position auf dem Kühlkörper 30 positioniert werden kann.

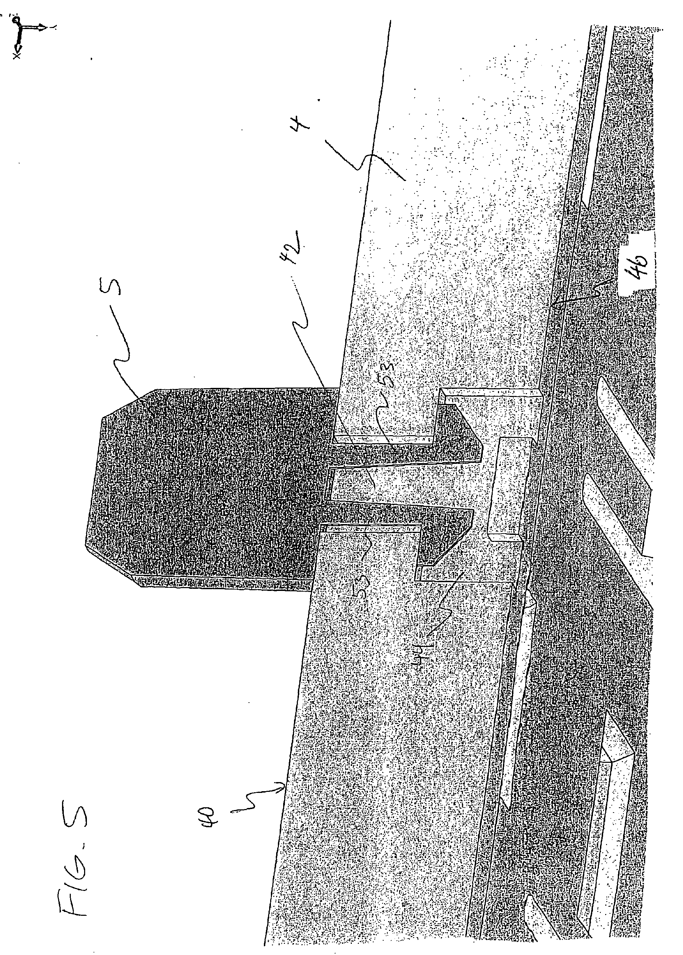

Figur 5 zeigt einen Schnitt durch ein Halteelement 5, das in eine zugeordnete Ausnehmung 42 eines Gehäuses 4 eingreift. Das Halteelement 5 wird von der Unterseite 40 des Gehäuses 4 her in die Ausnehmung 42 eingeführt. Das Halteelement 5 weist zwei Rastfinger 53 auf, die in eine entsprechende Rastvertiefung 44 der Ausnehmung 42 einrasten. Durch Einführen eines geeigneten Werkzeugs von der Oberseite 46 des Gehäuses 4 her können die federnden Rastfinger 53 aufeinander zu bewegt werden, wodurch die Rast-Schnapp-Verbindung gelöst wird und das Halteelement 5 zerstörungsfrei von dem Gehäuse 4 abgenommen werden kann.

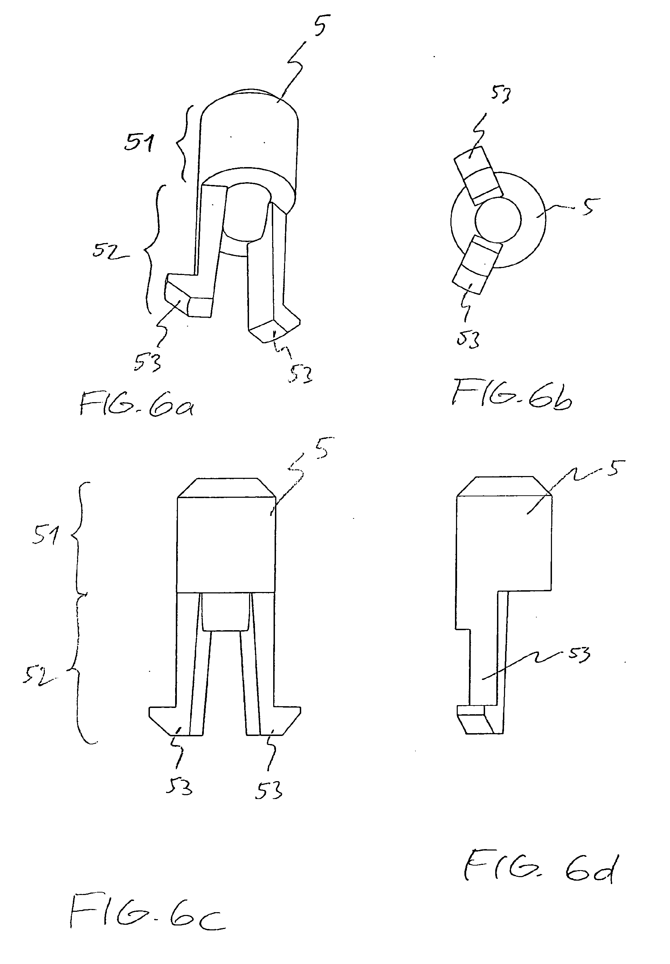

Die Figuren 6a bis 6d zeigen verschiedene Ansichten eines Halteelements 5, wie es die erfindungsgemäße Anordnung mit dem Leistungshalbleitermodul 1 aufweist.

Figur 6a zeigt eine Schrägansicht von unten her auf das Halteelement 5. Das Halteelement 5 weist einen oberen Abschnitt 51 auf, der in eine Ausnehmung 30 des Kühlkörpers 3 eingreift, sowie einen unteren Abschnitt 52 auf, der in die Gehäuseausnehmung 42 des Gehäuses 4 eingreift. Der untere Abschnitt 52 weist zwei federnde Rastfinger 53 auf, die mit der zugeordneten Ausnehmung 42 des Gehäuses 4 eine Rast-Schnapp-Verbindung ausbilden.

Figur 6b zeigt eine Untersicht des in Figur 6a dargestellten Halteelements 5.

Figur 6c zeigt eine Seitenansicht des in Figur 6a dargestellten Halteelements 5.

Figur 6d zeigt eine zweite Seitenansicht des in Figur 6a dargestellten Halteelements 5.

### Bezugszeichenliste:

- 1: Leistungshalbleitermodul
- 2: Substrat
- 20: Leistungshalbleiterelement
- 3: Kühlkörper
- 30: Ausnehmung des Kühlkörpers 3
- 4: Gehäuse
- 40: Unterseite des Gehäuses 4
- 41: Aussparung des Gehäuses 4 zur Aufnahme des Substrats 2
- 42: Ausnehmung des Gehäuses 4
- 43: Rahmen des Gehäuses 4
- 44: Rastvertiefung
- 45: Befestigungsloch
- 5: Halteelement
- 51: dem Kühlkörper 3 zugewandter Abschnitt des Halteelements 5
- 52: in die Ausnehmung 42 eingreifender Abschnitt des Halteelements 5
- 53: Rastfinger des Halteelements 5
- 54: Vorsprung des Halteelements 5
- 6: Wärmeleitschicht

## Patentansprüche

1. Anordnung mit einem Leistungshalbleitermodul (1), umfassend ein Substrat (2) mit mindestens einem Leistungshalbleiterelement (20) und ein Gehäuse (4), und einem Kühlkörper (3) zur Ableitung von Abwärme des mindestens einen Leistungshalbleiterelements (20), wobei das Gehäuse (4) eine an einer dem Kühlkörper (3) zugewandten Unterseite (40) des Gehäuses (4) angeordnete Aussparung (41) zur Aufnahme des Substrats (2) aufweist,
**dadurch gekennzeichnet,**
**dass** das Leistungshalbleitermodul (1) mindestens ein Halteelement (5) aufweist, das in eine dem mindestens einen Halteelement (5) zugeordnete Ausnehmung (42) an der Unterseite (40) des Gehäuses (4) eingreift und so ausgebildet ist, dass es eine Bewegung des Substrats (2) in Richtung der Unterseite (40) des Gehäuses (4) begrenzt.

2. Anordnung nach Anspruch 1,
**dadurch gekennzeichnet,**
**dass** das mindestens eine Halteelement (5) so ausgebildet ist, dass es bei der Montage des Gehäuses (4) auf dem Kühlkörper (3) zur Positionierung des Gehäuses (4) auf dem Kühlkörper (3) in eine zugeordnete Ausnehmung (30) des Kühlkörpers (3) eingreift.

3. Anordnung nach Anspruch 2,
**dadurch gekennzeichnet,**
**dass** die dem mindestens einen Halteelement (5) zugeordnete Ausnehmung (30) des Kühlkörpers (3) und ein dem Kühlkörper (3) zugewandter Abschnitt (51) des Halteelements (5), der in besagte Ausnehmung (30) eingreift, eine einander entsprechende Form aufweisen.

4. Anordnung nach einem der Ansprüche 1 bis 3,
**dadurch gekennzeichnet,**
**dass** ein dem Kühlkörper (3) zugewandter Abschnitt (51) des mindestens einen Halteelements (5) zylinderförmig ausgebildet ist.

5. Anordnung nach einem der Ansprüche 1 bis 4,
**dadurch gekennzeichnet,**
**dass** das mindestens eine Halteelement (5) einen in die Aussparung (41) zur Aufnahme des Substrats (2) ragenden Vorsprung (54) aufweist, der die Bewegung des Substrats (2) in Richtung zu der Unterseite (40) des Gehäuses (4) begrenzt.

6. Anordnung nach einem der Ansprüche 1 bis 5,
**dadurch gekennzeichnet,**
**dass** das Gehäuse (4) einen umlaufenden Gehäuserahmen (43) aufweist, in dem die Ausnehmung (42), in die das Halteelement (5) eingreift, angeordnet ist.

7. Anordnung nach einem der Ansprüche 1 bis 6,
**dadurch gekennzeichnet,**
**dass** die Gehäuseausnehmung (42) an der Unterseite (40) des Gehäuses (4) als ein zu der Unterseite (40) des Gehäuses (4) hin offenes Sackloch ausgebildet ist, in das das mindestens eine Halteelement (5) von der Unterseite (40) des Gehäuses (4) her eingreift.

8. Anordnung nach einem der Ansprüche 1 bis 7,
**dadurch gekennzeichnet,**
**dass** das mindestens eine Halteelement (5) als ein Rast-Zentrier-Halter ausgebildet ist.

9. Anordnung nach einem der Ansprüche 1 bis 8,
**dadurch gekennzeichnet,**
**dass** das mindestens eine Halteelement (5) mit dem Gehäuses (4) mittels einer lösbaren Verbindung verbunden ist.

10. Anordnung nach Anspruch 9,
**dadurch gekennzeichnet,**
**dass** das Halteelement (5) an einem in die Gehäuseausnehmung (42) eingreifenden Abschnitt (52) ein Außengewinde und die Gehäuseausnehmung (42) ein dem Außengewinde zugeordnetes Innengewinde aufweist.

11. Anordnung nach Anspruch 9,
**dadurch gekennzeichnet,**
**dass** das Halteelement (5) an einem in die Gehäuseausnehmung (42) eingreifenden Abschnitt (52) mindestens einen federnden Rastfinger (53) und die Gehäuseausnehmung (42) eine dem Rastfinger (53) zugeordnete Rastvertiefung (44) aufweist.

12. Anordnung nach einem der Ansprüche 1 bis 11,
**dadurch gekennzeichnet,**
**dass** das mindestens eine Halteelement (5) mittels einer Klebeverbindung in der zugeordneten Gehäuseausnehmung (42) fixiert ist.

13. Anordnung nach einem der Ansprüche 1 bis 12,
**dadurch gekennzeichnet,**
**dass** das Leistungshalbleitermodul (1) mindestens zwei, vorzugsweise mindestens drei, Halteelemente (5) umfasst.

14. Anordnung nach einem der Ansprüche 1 bis 10,
**dadurch gekennzeichnet,**
**dass** das Leistungshalbleitermodul (1) eine von einer Wärmeleitpaste gebildete Wärmeleitschicht (6) zwischen dem Substrat (2) und dem Kühlkörper (3) aufweist.

15. Verfahren zur Herstellung einer Anordnung mit einem Leistungshalbleitermodul (1), insbesondere nach einem der Ansprüche 1 bis 14, wobei das Verfahren folgende Schritte aufweist:
Bereitstellen eines Substrats (2) mit mindestens einem
Leistungshalbleiterelement (20);
Einsetzen des Substrats in eine Aussparung (41) eines Gehäuses (4), die an einer einem Kühlkörper (3) zugewandten Unterseite (40) des Gehäuses (4) angeordnet ist;
Einbringen mindestens eines Halteelements (5) in eine dem mindestens einen Halteelement (5) zugeordnete Ausnehmung (42) an der Unterseite (40) des Gehäuses (4) zur Begrenzung einer Bewegung des Substrats (2) in Richtung zu der Unterseite (40) des Gehäuses (4); und
Montage des Gehäuses (4) auf dem Kühlkörper (3), wobei die Unterseite (40) des Gehäuses (4) auf dem Kühlkörper (3) angeordnet ist.

16. Verfahren nach Anspruch 15,
**dadurch gekennzeichnet,**
**dass** das Verfahren weiter folgenden Schritt aufweist:
Positionierung des Gehäuses (4) auf dem Kühlkörper (3) so, dass das mindestens eine Halteelement (5) in eine zugeordnete Ausnehmung (30) des Kühlkörpers (3) eingreift.

17. Verfahren nach Anspruch 15 oder Anspruch 16,
**dadurch gekennzeichnet,**
**dass** das Verfahren weiter folgenden Schritt aufweist:
Aufbringen einer von einer Wärmeleitpaste gebildeten Wärmeleitschicht (6) auf der dem Kühlkörper (3) zugewandten Seite des Substrats (2), bevor das mindestens eine Halteelement (5) in die Ausnehmung (42) des Gehäuses (4) eingebracht wird.
